# EUROPÄISCHE PATENTSCHRIFT

(11) **EP 3 282 542 B1**
(45) Veröffentlichungstag und Bekanntmachung des Hinweises auf die Patenterteilung: **15.05.2019**
(21) Anmeldenummer: 17186084.4
(22) Anmeldetag: 14.08.2017
(51) Int. Cl.: H02J 7/00, B25F 5/00, G01R 31/36, H01M 10/48

(54) **ELEKTRISCHE ENERGIESPEICHERVORRICHTUNG UND ELEKTROGERÄT**
ELECTRICAL ENERGY STORAGE DEVICE AND ELECTRICAL DEVICE
DISPOSITIF ÉLECTRIQUE DE STOCKAGE D'ÉNERGIE ET APPAREIL ÉLECTRIQUE

(30) Priorität: 12.08.2016 DE 102016115053
(43) Veröffentlichungstag der Anmeldung: 14.02.2018
(73) Patentinhaber: Alfred Kärcher SE & Co. KG, 71364 Winnenden (DE)
(72) Erfinder: Schmid, Jörg, 71397 Leutenbach (DE)
(74) Vertreter: Hoeger, Stellrecht & Partner Patentanwälte mbB

(56) Entgegenhaltungen:
- EP-A1- 2 756 808
- EP-A2- 0 938 919
- EP-A2- 2 003 761
- WO-A1-2013/186045
- DE-A1-102013 218 019
- DE-U1- 9 319 361
- GB-A- 2 378 032

## Beschreibung

Die vorliegende Erfindung betrifft eine elektrische Energiespeichervorrichtung für ein Elektrogerät mit mindestens einem elektrischen Verbraucher, welche elektrische Energiespeichervorrichtung mindestens einen elektrischen Energiespeicher, eine Anzeige und eine Steuereinrichtung zur Ansteuerung der Anzeige, um mindestens einen Parameter des Elektrogeräts und/oder der Energiespeichervorrichtung darzustellen, umfasst, wobei die Anzeige ausgebildet ist zum Darstellen des mindestens einen Parameters in mindestens zwei verschiedenen Ausrichtungen.

Ferner betrifft die vorliegende Erfindung ein Elektrogerät mit mindestens einem elektrischen Verbraucher und einer elektrischen Energiespeichervorrichtung zum Versorgen des elektrischen Verbrauchers mit elektrischer Energie.

Außerdem betrifft die vorliegende Erfindung ein Verfahren zum Darstellen mindestens eines Parameters eines Elektrogeräts und/oder einer elektrischen Energiespeichervorrichtung auf einer Anzeige der elektrischen Energiespeichervorrichtung, welche Anzeige ausgebildet ist zum Darstellen des mindestens einen Parameters in mindestens zwei verschiedenen Ausrichtungen.

Eine elektrische Energiespeichervorrichtung der eingangs beschriebenen Art in Form eines Akkupacks für ein Elektrogerät ist beispielsweise aus der DE 10 2013 218 019 A1 bekannt. Bei diesem Akkupack ändert sich die Darstellung auf der Anzeige in Abhängigkeit einer Positionsveränderung des Akkupacks im Raum, die mit einem Lagesensor bestimmt wird.

Bei der bekannten Energiespeichervorrichtung ist die Darstellung der Anzeige ausschließlich von einer Positionsänderung des Akkupacks im Raum, die durch den Lagesensor bestimmt wird, abhängig. Eine eindeutige Zuordnung der Ausrichtung der Darstellung des mindestens einen Parameters mit der Anzeige, und zwar je nachdem, wie die elektrische Energiespeichervorrichtung mit dem Elektrogerät verbunden ist, ist nicht möglich.

Aus der DE 10 2013 218 019 A1 sind Anzeigeeinrichtungen und Anzeigeverfahren bekannt. In der EP 2 756 808 A1 sind handgehaltene elektromechanische chirurgische Systeme mit einer Batteriefachdiagnoseanzeige beschrieben. Verfahren zur Orientierung einer Anzeige eines Geräts sind in der GB 2 378 031 A offenbart. Tragbare elektronische Spielgeräte und Anzeigeverfahren sind aus der EP 0938 919 A2 bekannt. In der EP 2 003 761 A2 sind Adapter für kabellose Elektrowerkzeuge beschrieben. Aus der DE 93 19 361 U1 ist eine batteriebetriebene Handwerkzeugmaschine bekannt. Die WO 2013/186045 A1 betrifft Handwerkzeugmaschinen.

Es ist daher eine Aufgabe der vorliegenden Erfindung, eine elektrische Energiespeichervorrichtung, ein Elektrogerät und ein Verfahren der eingangs beschriebenen Art so zu verbessern, dass eine Ausrichtung der Darstellung der Anzeige in Abhängigkeit der Kombination von miteinander zusammenwirkender elektrischer Energiespeichervorrichtung und Elektrogerät möglich ist.

Diese Aufgabe wird bei einer elektrischen Energiespeichervorrichtung der eingangs beschriebenen Art erfindungsgemäß dadurch gelöst, dass die Energiespeichervorrichtung eine Dekodiereinrichtung umfasst zum Dekodieren eines am Elektrogerät angeordneten oder in diesem hinterlegten spezifischen Gerätekodes, dass die Dekodiereinrichtung mit der Steuereinrichtung zusammenwirkend ausgebildet ist und dass die Steuereinrichtung ausgebildet ist zum Darstellen des mindestens einen Parameters in einer zum spezifischen Gerätekode korrespondierenden Ausrichtung der mindestens zwei verschiedenen Ausrichtungen, dass die elektrische Energiespeichervorrichtung mindestens ein erstes Kopplungselement einer mindestens ein zweites, am Elektrogerät angeordnetes oder ausgebildetes Kopplungselement umfassenden Kopplungseinrichtung zum kraft- und/oder formschlüssigen Koppeln der elektrischen Energiespeichervorrichtung mit einem Elektrogerät in einer Kopplungsstellung umfasst, in welcher die elektrische Energiespeichervorrichtung und das Elektrogerät mechanisch und elektrisch miteinander gekoppelt sind und das mindestens eine erste und das mindestens eine zweite Kopplungselement kraft- und/ oder formschlüssig in Eingriff stehen, und dass die Dekodiereinrichtung im Bereich des mindestens einen ersten Kopplungselements derart angeordnet ist, dass der spezifische Gerätekode in der Kopplungsstellung der Kopplungseinrichtung vom Elektrogerät auf die Energiespeichervorrichtung sicher und insbesondere eindeutig übertragbar ist.

Die erfindungsgemäß vorgeschlagene Weiterbildung einer elektrischen Energiespeichervorrichtung der eingangs beschriebenen Art ermöglicht es insbesondere, eine Ausrichtung der Darstellung der Anzeige vorzugeben und optional auch zu fixieren in Abhängigkeit des Elektrogeräts, mit dem die elektrische Energiespeichervorrichtung gekoppelt ist, um das Elektrogerät mit elektrischer Energie zu versorgen. Wird die elektrische Energiespeichervorrichtung mit oder ohne das gekoppelte Elektrogerät gedreht, ändert sich die Ausrichtung der Darstellung auf der Anzeige also nicht, da die Ausrichtung Darstellung des mindestens einen Parameters bezüglich der Anzeige fixiert ist. Allerdings kann die Ausrichtung der Darstellung geändert werden, wenn die elektrische Energiespeichervorrichtung mit einem anderen Elektrogerät gekoppelt wird, das einen anderen spezifischen Gerätecode aufweist. So kann beispielsweise die Ausrichtung der Darstellung der Anzeige in Abhängigkeit einer bestimmten Kopplungsstellung oder einer Ausrichtung der elektrischen Energiespeichervorrichtung relativ zum Elektrogerät geändert werden. Beispielsweise kann so die Ausrichtung der Darstellung der Anzeige eines oder mehrerer Parameter des Elektrogeräts und/oder der Energiespeichervorrichtung geändert werden, wenn die elektrische Energiespeichervorrichtung von einem ersten Elektrogerät abgekoppelt und mit einem zweiten Elektrogerät gekoppelt wird. Beispielsweise kann sich bei der Kopplung der elektrischen Energiespeichervorrichtung mit einem anderen Elektrogerät die Einbaulage der elektrischen Energiespeichervorrichtung relativ zum Elektrogerät ändern. So kann die elektrische Energiespeichervorrichtung bei einem ersten Elektrogerät insbesondere von oben aufgesetzt werden, bei einem anderen Elektrogerät von unten mit diesem gekoppelt werden. Durch das Vorsehen der Dekodiereinrichtung an der elektrischen Energiespeichervorrichtung kann so in Abhängigkeit des spezifischen Gerätekodes des Elektrogeräts die Ausrichtung der Darstellung der Anzeige fest vorgegeben werden, und zwar in Abhängigkeit des Elektrogeräts, das mit der elektrischen Energiespeichervorrichtung zum Versorgen des Verbrauches des Elektrogeräts mit elektrischer Energie gekoppelt ist. Die Anzahl der verschiedenen Ausrichtungen wird vorzugsweise durch eine Anzahl der möglichen Kombinationen vorgegeben, die für eine Kopplung zwischen der elektrischen Energiespeichervorrichtung und den mit dieser zur Kopplung vorgesehenen Elektrogeräten möglich ist. Als mögliche Parameter können insbesondere eine verbleibende Akkulaufzeit, ein Ladestatus des mindestens einen Energiespeichers oder eine Anzahl der Ladezyklen der Energiespeichervorrichtung angezeigt werden. Gemäß der bevorzugten Ausführungsform der elektrischen Energiespeichervorrichtung ist vorgesehen, dass diese mindestens ein erstes Kopplungselement einer mindestens ein zweites, am Elektrogerät angeordnetes oder ausgebildetes Kopplungselement umfassenden Kopplungseinrichtung zum kraft- und/oder formschlüssigen Koppeln der elektrischen Energiespeichervorrichtung mit einem Elektrogerät in einer Kopplungsstellung umfasst, in welcher Kopplungsstellung die elektrische Energiespeichervorrichtung und das Elektrogerät mechanisch und elektrisch miteinander gekoppelt sind und das mindestens eine erste und das mindestens eine zweite Kopplungselement kraft- und/ oder formschlüssig in Eingriff stehen. Das mindestens eine erste Kopplungselement ermöglicht also insbesondere ein definiertes kraft- und/oder formschlüssiges Koppeln der elektrischen Energiespeichervorrichtung mit mindestens einem Elektrogerät. Insbesondere kann die elektrische Energiespeichervorrichtung mit mehreren unterschiedlichen Elektrogeräten gekoppelt werden, wenn das mindestens eine zweite Kopplungselement der mehreren unterschiedlichen Elektrogeräte korrespondierend zum mindestens einen ersten Kopplungselement der elektrischen Energiespeichervorrichtung ausgebildet ist. Dies ermöglicht es insbesondere, die Energiespeichervorrichtung und die Elektrogeräte mechanisch und elektrisch miteinander zu koppeln.

Günstig ist es, wenn die mindestens zwei Ausrichtungen parallel oder im Wesentlichen parallel zu seitlichen Begrenzungen der Anzeige verlaufen. Beispielsweise kann dies sinnvoll sein, wenn als Anzeige ein Display mit einer vorgegebenen Anzahl von in einem rechteckigen Raster angeordneten Bildpunkten vorgesehen ist. So kann insbesondere eine optimale Darstellung der anzuzeigenden Parameter der elektrischen Energiespeichervorrichtung oder des Elektrogeräts auf der Anzeige sichergestellt werden.

Vorzugsweise sind die mindestens zwei Ausrichtungen um ein ganzzahliges Vielfaches von 90° relativ zueinander im Uhrzeigersinn oder im Gegenuhrzeigersinn verdreht. So lassen sich insgesamt vier verschiedene Ausrichtungen der Darstellung mindestens eines Parameters auf der Anzeige vorgeben. Beispielsweise sind zwei Ausrichtungen möglich, die relativ zueinander um 180° verdreht sind.

Gemäß einer Ausführungsform der Energiespeichervorrichtung kann vorgesehen sein, dass die elektrische Energiespeichervorrichtung eine Empfangseinrichtung umfasst, welche mit der Dekodiereinrichtung zusammenwirkend und zum Empfangen, insbesondere zum berührungslosen Empfangen, des von einer Sendeeinrichtung des Elektrogeräts gesendeten spezifischen Gerätekodes ausgebildet ist. Mit der Empfangseinrichtung kann also insbesondere ein mit einer Sendeeinrichtung des Elektrogeräts gesendeter spezifischer Gerätecode des Elektrogeräts empfangen und an die Dekodiereinrichtung übergeben oder weitergeleitet werden. Insbesondere eine berührungslose Übertragung des spezifischen Gerätekodes ermöglicht es, auf eine direkte elektrische Kontaktierung zwischen der elektrischen Energiespeichervorrichtung und dem Elektrogerät zum Übergeben des spezifischen Gerätekodes zu verzichten.

Auf einfache Weise lässt sich ein spezifischer Gerätecode berührungslos empfangen, wenn die Empfangseinrichtung eine RFID-Chip-Ausleseeinrichtung umfasst. So kann der spezifische Gerätekode des Elektrogeräts beispielsweise in einem Speicher eines am Elektrogerät angeordneten RFID-Chips hinterlegt werden.

Besonders kostengünstig ausbilden lässt sich die elektrische Energiespeichervorrichtung, wenn die Dekodiereinrichtung mindestens einen Magnetfeldsensor und/oder eine magnetisch betätigbare Schalteinrichtung umfasst. Dies ermöglicht es insbesondere, als Kodiereinrichtung beispielsweise ein Kodierelement in Form eines Magneten vorzusehen. So können insbesondere auf einfache Weise zwei spezifische Gerätekodes des Elektrogeräts vorgegeben werden, nämlich ein erster Gerätekode dann, wenn ein Magnet vorgesehen ist oder ein zweiter Gerätekode, wenn kein Magnet vorgesehen ist. Dies ermöglicht es insbesondere, die Ausrichtung der Darstellung der Anzeige zu ändern, und zwar je nachdem, ob ein Magnet am Elektrogerät als Kodierelement angeordnet ist oder nicht.

Besonders einfach und kostengünstig ausbilden lässt sich die elektrische Energiespeichervorrichtung, wenn der Magnetfeldsensor in Form eines Hall-Sensors ausgebildet ist und/oder wenn die magnetisch betätigbare Schalteinrichtung einen Reed-Schalter umfasst. Hall-Sensoren lassen sich beispielsweise in die Schalteinrichtung integrieren. Sie können insbesondere Magnetfelder hochpräzise messen.

Vorzugsweise ist das mindestens eine erste Kopplungselement in Form eines Kopplungsvorsprungs oder in Form einer Kopplungsausnehmung ausgebildet ist. Es können auch zwei oder mehr Kopplungsvorsprünge und optional auch zwei oder mehr Kopplungsausnehmungen vorgesehen sein, die zwei oder mehr erste Kopplungselemente bilden. Auch Kombinationen von Kopplungsvorsprüngen und Kopplungsausnehmungen zur Ausbildung von zwei oder mehr ersten Kopplungselementen sind möglich.

Günstig ist es, wenn das mindestens eine erste Kopplungselement ausgebildet ist zum wahlweisen Koppeln mit einer Mehrzahl von insbesondere unterschiedlichen Elektrogeräten. Wie beschrieben hat dies den Vorteil, dass für unterschiedliche Elektrogeräte ein bestimmter Typ von elektrischer Energiespeichervorrichtung vorgesehen werden kann. Abhängig vom jeweiligen Elektrogerät kann dann die Darstellung der Anzeige in der jeweils gewünschten Weise automatisch ausgerichtet werden.

Vorteilhaft ist es, wenn die Anzeige in Form einer LED-Segmentanzeige oder in Form eines LCD-Displays oder in Form eines LED-Farbdisplays ausgebildet ist. Mit derartigen Anzeigen lassen sich Parameter der elektrischen Energiespeichervorrichtung und/oder des Elektrogeräts in gewünschter Weise und unterschiedlichen Ausrichtungen darstellen.

Vorteilhafterweise ist die Anzeige ausgebildet zum Darstellen des mindestens einen Parameters in zwei, drei oder vier verschiedenen Ausrichtungen. So lassen sich insbesondere Parameter in mindestens zwei unterschiedlichen Ausrichtungen darstellen, welche Ausrichtungen um ganzzahliges Vielfaches von 90° relativ zueinander im Uhrzeigersinn oder im Gegenuhrzeigersinn verdreht sind.

Zum Versorgen von Elektrogeräten mit elektrischer Energie ist es vorteilhaft, wenn der mindestens eine elektrische Energiespeicher in Form einer wiederaufladbaren Batterie ausgebildet ist. So lässt sich die elektrische Energiespeichervorrichtung mehrfach aufladen und zum Versorgen eines Elektrogeräts mit elektrischer Energie einsetzen.

Vorzugsweise umfasst die elektrische Energiespeichervorrichtung eine Mehrzahl von elektrischen Energiespeichern. Insbesondere kann so über die Anzahl der elektrischen Energiespeicher eine Kapazität der elektrischen Energiespeichervorrichtung in gewünschter Weise vorgegeben werden. Durch entsprechende Anordnung der elektrischen Energiespeicher kann zudem auch eine von der elektrischen Energiespeichervorrichtung bereitstellbare Versorgungsspannung vorgegeben werden.

Die eingangs gestellte Aufgabe wird ferner bei einem Elektrogerät der eingangs beschriebenen Art erfindungsgemäß dadurch gelöst, dass das Elektrogerät eine Kodiereinrichtung mit einem spezifischen Gerätekode umfasst und dass die elektrische Energiespeichervorrichtung in Form einer der oben beschriebenen elektrischen Energiespeichervorrichtungen ausgebildet ist.

Durch die Kodiereinrichtung am Elektrogerät kann insbesondere ein spezifischer Gerätekode des Elektrogeräts bereitgestellt werden, welcher mit der Dekodiereinrichtung der elektrischen Energiespeichervorrichtung ausgelesen werden kann, um dann die Darstellung des mindestens einen Parameters auf der Anzeige der elektrischen Energiespeichervorrichtung in Abhängigkeit des spezifischen Gerätekodes des Elektrogeräts auszurichten. Ferner weist ein derart weitergebildetes Elektrogerät auch die bereits oben in Verbindung mit bevorzugten Ausführungsformen elektrischer Energiespeichervorrichtungen beschriebenen Vorteile auf.

Vorteilhafterweise umfasst die Kodiereinrichtung mindestens ein Kodierelement. Die Kodiereinrichtung kann zwei, drei oder auch mehr Kodierelemente umfassen. Beispielsweise kann über die Zahl der wahlweise an einem Elektrogerät angeordneten Kodierelemente die Anzahl der möglichen Ausrichtungen der Darstellung des mindestens einen Parameters auf oder mit der Anzeige an der elektrischen Energiespeichervorrichtung vorgegeben werden. Insbesondere lassen sich zwei Ausrichtungen vorgeben, wenn die Kodiereinrichtung wahlweise ein oder kein Kodierelement umfasst, welches bei Kopplung der elektrischen Energiespeichervorrichtung mit dem Elektrogerät detektiert oder bei Abwesenheit des Kodierelements nicht detektiert wird. So können insbesondere zwei definierte Ausrichtungen der Darstellung der Anzeige zwei derart unterschiedlich kodierten Elektrogeräten spezifisch zugeordnet werden.

Vorzugsweise ist das mindestens eine Kodierelement in Form eines magnetischen oder magnetisierbaren Kodierelements ausgebildet. Derartige Kodierelemente lassen sich insbesondere berührungslos detektieren. Damit kann ein spezifischer Gerätekode auch berührungslos von der elektrischen Energiespeichervorrichtung erfasst werden.

Besonders einfach und kostengünstig ausbilden lässt sich das Elektrogerät, wenn das magnetische Kodierelement in Form eines Dauermagneten oder in Form eines Elektromagneten ausgebildet ist. Durch das Vorsehen eines Dauermagneten kann die Kodierung dauerhaft vorgeben werden. Wird ein Elektromagnet vorgesehen, kann beispielsweise bei Bedarf eine Kodierung auch geändert werden durch entsprechende Ansteuerung des Dauermagneten, insbesondere durch Aktivieren oder Deaktivieren desselben, wenn die elektrische Energiespeichervorrichtung mit dem Elektrogerät mechanisch und elektrisch gekoppelt ist.

Vorzugsweise umfasst die Kodiereinrichtung mindestens ein Speicherelement und ist der spezifische Gerätekode auf dem Speicherelement gespeichert. Durch das Vorsehen eines Speicherelements ist es möglich, den spezifischen Gerätekode temporär oder dauerhaft zu hinterlegen. Insbesondere kann in Abhängigkeit der Art und Größe des Speicherelements eine Anzahl unterschiedlicher spezifischer Gerätekodes vorgegeben werden, um Kombinationen von Elektrogeräten und elektrischen Energiespeichervorrichtungen zu definieren und die Ausrichtung der Darstellung der Anzeige der elektrischen Energiespeichervorrichtung in Abhängigkeit der Kombination von Elektrogerät und elektrischer Energiespeichervorrichtung, welche miteinander zusammenwirken.

Ferner ist es günstig, wenn das Elektrogerät eine Sendeeinrichtung umfasst, wenn die Kodiereinrichtung mit der Sendeeinrichtung zusammenwirkend ausgebildet ist, wenn die Dekodiereinrichtung mit einer Empfangseinrichtung zusammenwirkend ausgebildet ist und wenn die Sendeeinrichtung ausgebildet ist zum Senden, insbesondere zum berührungslosen Senden, des spezifischen Gerätekodes an die Empfangseinrichtung. Das Vorsehen einer Sendeeinrichtung und einer Empfangseinrichtung ermöglicht es inbesondere auf einfache Weise die Übertragung des spezifischen Gerätekodes vom Elektrogerät auf die elektrische Energiespeichervorrichtung. Insbesondere kann bei entsprechender Ausbildung der Sendeeinrichtung und der Empfangseinrichtung der spezifische Gerätekode berührungslos übertragen werden.

Auf einfache und kostengünstige Weise ausbilden lässt sich das Elektrogerät, wenn die Kodiereinrichtung einen RFID-Chip umfasst. Insbesondere lässt sich ein Speicher eines solchen RFID-Chips berührungslos auslesen mit einer entsprechenden Leseeinrichtung, die insbesondere an der elektrischen Energiespeichervorrichtung angeordnet oder ausgebildet sein kann.

Ferner ist es vorteilhaft, wenn das Elektrogerät eine Kopplungseinrichtung zum kraft- und/oder formschlüssigen Koppeln des Elektrogeräts und der elektrischen Energiespeichervorrichtung in einer Kopplungsstellung umfasst, in welcher das Elektrogerät und die elektrische Energiespeichervorrichtung mechanisch und elektrisch miteinander gekoppelt sind. Die Kopplungseinrichtung ermöglicht es insbesondere, das Elektrogerät und die elektrische Energiespeichervorrichtung in definierte Weise mechanisch und elektrisch miteinander zu verbinden.

Auf einfache Weise ausbilden lässt sich das Elektrogerät, wenn die Kopplungseinrichtung mindestens ein erstes Kopplungselement und mindestens ein zweites Kopplungselement umfasst, wenn das mindestens eine erste Kopplungselement an der elektrischen Energiespeichervorrichtung angeordnet oder ausgebildet ist, wenn das mindestens eine zweite Kopplungselement am Elektrogerät angeordnet oder ausgebildet ist und wenn das mindestens eine erste und das mindestens eine zweite Kopplungselement in der Kopplungsstellung kraft- und/oder formschlüssig in Eingriff stehen. Durch das mindestens eine erste und das mindestens eine zweite Kopplungselement lassen sich das Elektrogerät und die elektrische Energiespeichervorrichtung in definierter Weise in der Kopplungsstellung miteinander verbinden.

Vorteilhaft ist es, wenn das mindestens eine erste und das mindestens eine zweite Kopplungselement in einer Trennstellung, in welcher das Elektrogerät und die elektrische Energiespeichervorrichtung vollständig voneinander getrennt sind, außer Eingriff stehen. Diese Ausgestaltung der Kopplungseinrichtung ermöglicht es insbesondere, die elektrische Energiespeichervorrichtung und das Elektrogerät voneinander zu trennen. Beispielsweise kann so eine elektrische Energiespeichervorrichtung, wenn sie keine elektrische Energie mehr enthält, also beispielsweise entladen ist, durch eine geladene elektrische Energiespeichervorrichtung ersetzt werden. So kann ein Benutzer des Elektrogeräts das Elektrogerät weiter einsetzen. Insbesondere kann die elektrische Energiespeichervorrichtung auch mit dem mindestens einen ersten Kopplungselement mit einem korrespondierenden Kopplungselement einer elektrischen Ladevorrichtung in Eingriff gebracht werden, um den mindestens einen Energiespeicher wieder aufzuladen.

Vorzugsweise sind die Kodiereinrichtung und die Dekodiereinrichtung in der Kopplungsstellung derart angeordnet, dass der spezifische Gerätekode mit der Dekodiereinrichtung dekodierbar ist. Beispielsweise kann so der spezifische Gerätekode sicher vom Elektrogerät auf die elektrische Energiespeichervorrichtung übertragen werden. Dies muss nur dann zwingend möglich sein, wenn das Elektrogerät und die elektrische Energiespeichervorrichtung die Kopplungsstellung einnehmen. Beispielsweise lässt sich die spezifische Dekodierbarkeit des spezifischen Gerätekodes über eine geeignete räumliche Anordnung der Kodiereinrichtung und der Dekodiereinrichtung relativ zueinander erreichen.

Günstig kann es ferner sein, wenn das Elektrogerät ausgebildet ist zum wahlweisen Koppeln mit einer Mehrzahl von insbesondere unterschiedlichen elektrischen Energiespeichervorrichtungen. Beispielsweise kann so wie beschrieben eine elektrische Energiespeichervorrichtung, die keine elektrische Energie mehr enthält, vom Elektrogerät getrennt und durch eine andere elektrische Energiespeichervorrichtung ersetzt werden, die noch elektrische Energie enthält. Ferner kann so das Elektrogerät auch mit unterschiedlichen elektrischen Energiespeichervorrichtungen, die unterschiedliche spezifische Energiekapazitäten aufweisen, verbunden werden. Beispielsweise kann so eine Größe der elektrischen Energiespeichervorrichtung, insbesondere eine Kapazität derselben, in Abhängigkeit von einem Einsatzzweck des Elektrogeräts ausgewählt werden. Insbesondere kann so das Elektrogerät mit einem minimalen Gewicht von einem Benutzer eingesetzt werden.

Vorteilhaft ist es, wenn der elektrische Verbraucher in Form eines Elektromotors ausgebildet ist. Beispielsweise lassen sich so Elektrogeräte mit bewegbaren Werkzeugen ausbilden, beispielsweise Heckenscheren, Rasenmäher, Kettensägen, Bohrmaschinen oder dergleichen.

Die eingangs gestellte Aufgabe wird ferner bei einem Verfahren der eingangs beschriebenen Art erfindungsgemäß dadurch gelöst, dass die elektrische Energiespeichervorrichtung mindestens ein erstes Kopplungselement einer mindestens ein zweites, am Elektrogerät angeordnetes oder ausgebildetes Kopplungselement umfassenden Kopplungseinrichtung zum kraft- und/oder formschlüssigen Koppeln der elektrischen Energiespeichervorrichtung mit einem Elektrogerät in einer Kopplungsstellung umfasst, in welcher die elektrische Energiespeichervorrichtung und das Elektrogerät mechanisch und elektrisch miteinander gekoppelt sind und das mindestens eine erste und das mindestens eine zweite Kopplungselement kraft- und/oder formschlüssig in Eingriff stehen, dass die elektrische Energiespeichervorrichtung und das Elektrogerät mechanisch und elektrisch miteinander gekoppelt werden, so dass sie die Kopplungsstellung einnehmen, und dass ein am Elektrogerät angeordneter oder in diesem hinterlegter spezifischer Gerätekode ausgelesen und der mindestens eine Parameter in einer zum spezifischen Gerätekode korrespondierenden Ausrichtung der mindestens zwei verschiedenen Ausrichtungen auf der Anzeige dargestellt wird.

Wie beschrieben ist es so möglich, die Ausrichtung der Darstellung eines Parameters des Elektrogeräts und/oder der elektrischen Energiespeichervorrichtung in Abhängigkeit der Kombination von Elektrogerät und elektrischer Energiespeichervorrichtung in einer vorbestimmten Ausrichtung anzuzeigen.

Die nachfolgende Beschreibung bevorzugter Ausführungsformen der Erfindung dient im Zusammenhang mit der Zeichnung der näheren Erläuterung. Es zeigen:
- Figur 1:: eine schematische Darstellung einer mit einem Elektrogerät elektrisch und mechanisch gekoppelten elektrischen Energiespeichervorrichtung;
- Figur 2:: eine schematische Darstellung der Ausrichtung der Darstellung eines Parameters auf der Anzeige bei der Kopplung mit dem in Figur 1 dargestellten Elektrogerät; und
- Figur 3:: eine schematische Darstellung einer alternativen Ausrichtung der Darstellung eines Parameters auf der Anzeige der elektrischen Energiespeichervorrichtung bei Kopplung derselben mit einem zweiten, vom ersten Elektrogerät verschiedenen Elektrogerät.

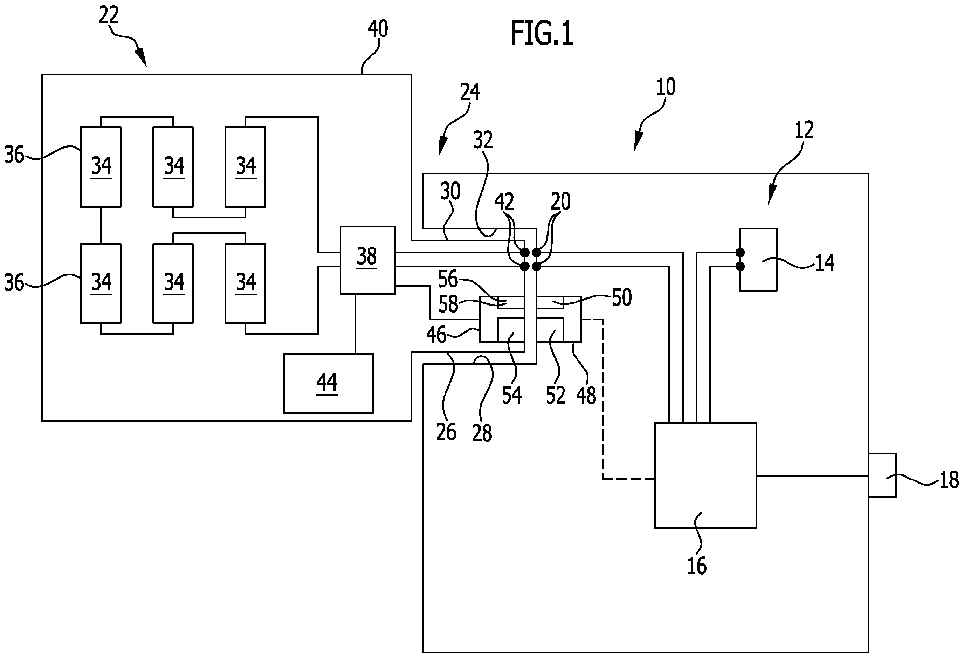

In Figur 1 ist schematisch ein erstes Elektrogerät 10 dargestellt. Es umfasst einen elektrischen Verbraucher 12, welcher insbesondere in Form eines Elektromotors 14 ausgebildet sein kann.

Das Elektrogerät 10 kann insbesondere eine Steuereinrichtung 16 umfassen, die einerseits mit dem Verbraucher 12 und andererseits mit einer optionalen Betätigungseinrichtung 18 steuerungswirksam verbunden ist. Die Betätigungseinrichtung 18 kann insbesondere in Form eines Schalters oder Tasters zum Aktivieren des Verbrauchers 12 ausgebildet sein.

Zwei Anschlusskontakte 20 zum Verbinden mit einer Energiespeichervorrichtung 22, beispielsweise in Form eines Akkupacks, sind mit der Steuereinrichtung 16, alternativ auch direkt mit dem Verbraucher 12, steuerungswirksam verbunden.

Zum mechanischen Koppeln des ersten Elektrogeräts 10 mit der elektrischen Energiespeichervorrichtung 22 ist eine Kopplungseinrichtung 24 vorgesehen. Diese umfasst mindestens ein erstes Kopplungselement 26 an der Energiespeichervorrichtung 22 und mindestens ein zweites Kopplungselement 28 am Elektrogerät 10.

Das mindestens eine erste Kopplungselement 26 kann insbesondere in Form eines Kopplungsvorsprungs 30 ausgebildet sein, das mindestens eine zweite Kopplungselement 28 insbesondere in Form einer zum Kopplungsvorsprung korrespondierenden Kopplungsausnehmung 32.

In einer Kopplungsstellung, wie sie schematisch in Figur 1 dargestellt ist, stehen die ersten und zweiten Kopplungselemente 26 und 28 kraft- und/oder formschlüssig miteinander in Eingriff. Das Elektrogerät 10 und die Energiespeichervorrichtung 22 sind so mechanisch und elektrisch miteinander gekoppelt.

Die elektrische Energiespeichervorrichtung 22 kann insbesondere mehrere elektrische Energiespeicher 34 in Form von wiederaufladbaren Batterien 36 umfassen. Diese sind wahlweise parallel oder, wie in Figur 1 schematisch dargestellt, in Serie geschaltet und mit einer Steuereinrichtung 38 der Energiespeichervorrichtung 22 steuerungswirksam verbunden.

Die Energiespeichervorrichtung 22 kann insbesondere ein Gehäuse 40 umfassen, in welchem die Energiespeicher 34 sowie die Steuereinrichtung 38 angeordnet ist. Das Gehäuse 40 kann insbesondere auch das mindestens eine erste Kopplungselement 26 umfassen oder einstückig, insbesondere monolithisch, mit diesem ausgebildet sein.

Die Steuereinrichtung 38 ist ferner mit zwei elektrisch leitenden Anschlusskontakten 42 verbunden. Die Anschlusskontakte 42 sind am ersten Kopplungselement 26 oder in einem Bereich desselben angeordnet oder ausgebildet.

Die Anschlusskontakte 20 sind im Bereich des zweiten Kopplungselements 28 angeordnet oder an diesem ausgebildet.

In der Kopplungsstellung steht jeweils einer der Anschlusskontakte 20 mit einem der Anschlusskontakte 42 elektrisch leitend in Verbindung. Durch diese elektrische Verbindung oder Kopplung kann elektrische Energie von der elektrischen Energiespeichervorrichtung 22 auf das Elektrogerät 10 übertragen werden.

Die Energiespeichervorrichtung 22 umfasst ferner eine Anzeige 44 zum Anzeigen mindestens eines Parameters des Elektrogeräts 10 oder der Energiespeichervorrichtung 22.

Die Anzeige 44 ist ausgebildet zum Anzeigen eines oder mehrerer Parameter in unterschiedlichen Ausrichtungen 72, 74. Die Ansteuerung der Anzeige 44 erfolgt über die Steuereinrichtung 38. Die Steuereinrichtung 38 kann optional auch ausgebildet sein zum Steuern und Überwachen eines Ladezustands und/ oder eines Entladezustands der Energiespeicher 34.

Die Energiespeichervorrichtung 22 umfasst ferner eine Dekodiereinrichtung 46 zum Dekodieren eines am Elektrogerät 10 angeordneten Gerätekodes. Der Gerätekode ist insbesondere in einer Kodiereinrichtung 48 am Elektrogerät 10 hinterlegt oder wird durch diese definiert. Die Dekodiereinrichtung 46 ist insbesondere steuerungswirksam mit der Steuereinrichtung 38 verbunden.

Je nach Ausgestaltung der Kodiereinrichtung 48 kann diese, wie in Figur 1 schematisch gestrichelt eingezeichnet, steuerungswirksam mit der Steuereinrichtung 16 verbunden sein.

Die Kodiereinrichtung 48 kann insbesondere ein oder mehrere Kodierelemente 50 umfassen.

Zum Übertragen des spezifischen Gerätekodes kann die Kodiereinrichtung 48 optional eine Sendeeinrichtung 52 umfassen. Zum Empfangen eines von der Sendeeinrichtung 52 gesendeten Signals kann die Dekodiereinrichtung 46 eine Empfangseinrichtung 54 umfassen. Diese Ausgestaltung ermöglicht es insbesondere, den spezifischen Gerätekode berührungslos vom Elektrogerät 10 auf die Energiespeichervorrichtung 22 zu übertragen.

Die Dekodiereinrichtung 46 kann insbesondere auch ein Dekodierelement 56 umfassen. Dieses kann insbesondere in Form eines Magnetfeldsensors 58 oder in Form einer magnetisch betätigbaren Schalteinrichtung ausgebildet sein. Der Magnetfeldsensor 58 kann beispielsweise in Form eines Hall-Sensors ausgebildet sein. Die magnetisch betätigbare Schalteinrichtung kann insbesondere in Form eines Reed-Schalters ausgebildet sein.

Die Dekodiereinrichtung 46 und die Kodiereinrichtung 48 sind insbesondere im Bereich der ersten und zweiten Kopplungselemente 26 und 28 jeweils derart angeordnet, dass der spezifische Gerätekode in der Kopplungsstellung der Kopplungseinrichtung 24 vom Elektrogerät 10 auf die Energiespeichervorrichtung 22 sicher und insbesondere eindeutig übertragbar ist.

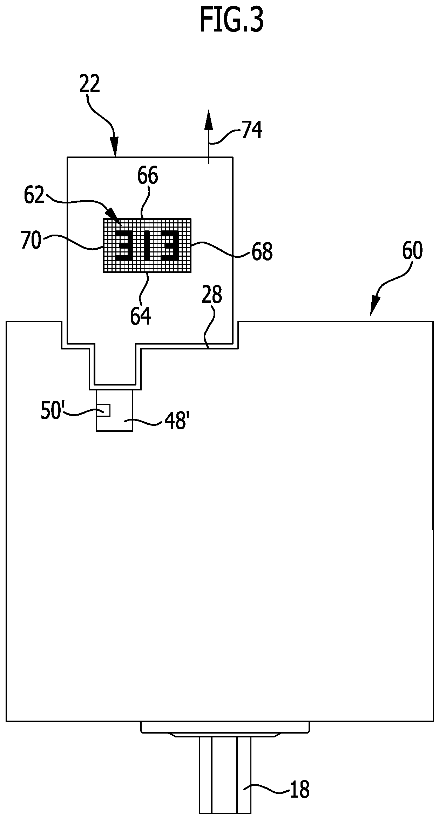

Die Energiespeichervorrichtung 22 kann insbesondere mit verschiedenen Elektrogeräten gekoppelt werden, beispielsweise mit dem ersten Elektrogerät 10 oder mit einem schematisch in Figur 3 dargestellten und mit dem Bezugszeichen 60 bezeichneten zweiten Elektrogerät.

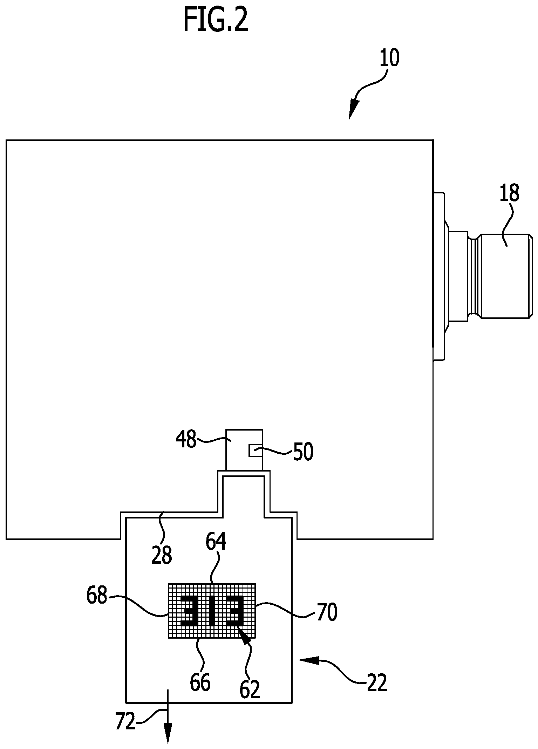

Wie schematisch in den Figuren 2 und 3 dargestellt, sind die zweiten Kopplungseinrichtungen 28 der Elektrogeräte 10 und 60 identisch ausgebildet, sodass sie mit dem ersten Kopplungselement 26 der Energiespeichervorrichtung 22 kraft- und/oder formschlüssig in Eingriff bringbar sind.

Allerdings kann die Kodiereinrichtung 48' des zweiten Elektrogeräts 60 einen anderen spezifischen Gerätekode definieren als die Kodiereinrichtung 48 des Elektrogeräts 10. Beispielsweise kann als spezifischer Gerätekode für das erste Elektrogerät 10 ein Kodierelement 50 in Form eines Magnets vorgesehen sein. Bei der Kodiereinrichtung 48' kann als Kodierelement 50' insbesondere auf einen solchen Magneten verzichtet werden. Das Kodierelement 50' ist daher unmagnetisch oder wird durch ein Kunststoffelement oder dergleichen gebildet.

Ist die Energiespeichervorrichtung 22 mit dem ersten Elektrogerät 10 gekoppelt, wie schematisch in Figur 2 dargestellt, wird mit der Dekodiereinrichtung 46 ein spezifischer Gerätekode dekodiert, der beispielsweise dem Vorhandensein des magnetischen Kodierelements 50 entspricht. Abhängig von diesem spezifischen Gerätekode wird ein Parameter 62 der elektrischen Energiespeichervorrichtung 22 oder des Elektrogeräts 10, wie in Figur 2 schematisch dargestellt, so auf der Anzeige 44 dargestellt und ausgerichtet, dass der Parameter 62, beispielsweise die Anzahl der von der Energiespeichervorrichtung 22 durchlaufenen Ladezyklen, in Figur 2 als Zahl "313" angegeben, so ausgerichtet ist, dass eine Seitenkante 64 oberhalb des dargestellten Parameters 62 und eine zur Seitenkante 64 parallele Seitenkante 66 der Anzeige 44 unterhalb des dargestellten Parameters 62 verlaufend angeordnet ist.

Wird die Energiespeichervorrichtung 22 vom ersten Elektrogerät 10 durch Entkoppeln getrennt und dann mit dem zweiten Elektrogerät 60 gekoppelt, detektiert die Dekodiereinrichtung 46, dass kein magnetisches Kodierelement 50' vorhanden ist. Die Steuereinrichtung 38 steuert dann die Anzeige 44 derart an, dass die Darstellung des Parameters 62, wiederum dargestellt als Zahl "313", bezogen auf die Seitenkanten 64 und 66 um 180° verdreht ist, also quasi auf dem Kopf steht. Die Seitenkante 64 verläuft damit parallel unterhalb des dargestellten Parameters 62, die Seitenkante 66 oberhalb des dargestellten Parameters 62.

Somit verläuft eine erste Ausrichtung der Darstellung des Parameters 62, symbolisiert durch den Pfeil 72, parallel zu den Seitenkanten 64 und 66. Eine zweite Ausrichtung der Darstellung des mindestens einen Parameters 62, symbolisiert durch den Pfeil 74, verläuft in genau entgegengesetzter Richtung.

In der beschriebenen Weise kann die Energiespeichervorrichtung 22 optional auch mit weiteren Elektrogeräten koppelbar sein, die entweder mit einem Gerätekode 0, der einem nicht Vorhandensein eines magnetischen Kodierelements 50' entspricht, oder dem Gerätekode 1, welcher einem Vorhandensein eines magnetischen Kodierelements 50 entspricht, versehen oder ausgestattet sind. Die Darstellung der Anzeige 44, insbesondere des Parameters 62, erfolgt dann entsprechend des detektierten spezifischen Gerätekodes in einer der beiden möglichen Ausrichtungen 72 oder 74.

Werden statt nur zwei Gerätekodes, wie beispielsweise "0 und 1", weitere Gerätekodes verwendet, so kann die Ausrichtung der Darstellung eines oder mehrerer Parameter 62 auch noch in weiteren Ausrichtungen erfolgen, beispielsweise senkrecht zu die Seitenkanten 64 und 66 miteinander verbindenden Seitenkanten 68 und 70. Vier verschiedene Gerätekodes können beispielsweise die Werte "0", "1", "2" und "3" aufweisen. Sie können beispielsweise realisiert werden durch keinen, einen, zwei oder drei Magnete, die entsprechende Kodierelemente 50 bilden.

Alternativ kann als Kodierelement 50 auch ein RFID-Chip verwendet werden, welcher auf einem Speicherelement einen spezifischen Gerätekode gespeichert hat. Dieser spezifische Gerätekode kann mit der Dekodiereinrichtung 46 ausgelesen werden, wenn die Energiespeichervorrichtung 22 mit dem jeweiligen Elektrogerät in der Kopplungsstellung kraft- und/oder formschlüssig gekoppelt ist, und zwar sowohl mechanisch als auch elektrisch. Abhängig vom ausgelesenen spezifischen Gerätekode steuert dann die Steuereinrichtung 38 die Anzeige 44 derart an, dass der anzuzeigende Parameter 62 in der gewünschten Ausrichtung dargestellt wird.

Die Ausrichtung 72 oder 74 der Darstellung des Parameters 62 auf der Anzeige 44 ändert sich nicht, wenn die Energiespeichervorrichtung 22 im Raum gedreht wird, und zwar weder wenn sie allein gedreht wird, also wenn sie nicht mit einem Elektrogerät 10 oder 60 gekoppelt ist und daher eine Trennstellung einnimmt, oder auch wenn sie mit einem Elektrogerät 10 oder 60 gekoppelt ist. Die Ausrichtung 72 oder 74 der Darstellung des mindestens einen Parameters 62 wird abhängig vom im Elektrogerät hinterlegten spezifischen Kode dann insbesondere mindestens so lange beibehalten, wie die Energiespeichervorrichtung 22 mit dem Elektrogerät 10 oder 60 gekoppelt ist.

### Bezugszeichenliste

- 10: erstes Elektrogerät
- 12: Verbraucher
- 14: Elektromotor
- 16: Steuereinrichtung
- 18: Betätigungseinrichtung
- 20: Anschlusskontakt
- 22: Energiespeichervorrichtung
- 24: Kopplungseinrichtung
- 26: erstes Kopplungselement
- 28: zweites Kopplungselement
- 30: Kopplungvorsprung
- 32: Kopplungsausnehmung
- 34: Energiespeicher
- 36: Batterie
- 38: Steuereinrichtung
- 40: Gehäuse
- 42: Anschlusskontakt
- 44: Anzeige
- 46: Dekodiereinrichtung
- 48: Kodiereinrichtung
- 48': Kodiereinrichtung
- 50: Kodierelement
- 50': Kodierelement
- 52: Sendeeinrichtung
- 54: Empfangseinrichtung
- 56: Dekodierelement
- 58: Magnetfeldsensor
- 60: zweites Elektrogerät
- 62: Parameter
- 64: Seitenkante
- 66: Seitenkante
- 68: Seitenkante
- 70: Seitenkante
- 72: erste Ausrichtung
- 74: zweite Ausrichtung

## Patentansprüche

1. Elektrische Energiespeichervorrichtung (22) für ein Elektrogerät (10, 60) mit mindestens einem elektrischen Verbraucher (12), welche elektrische Energiespeichervorrichtung (22) mindestens einen elektrischen Energiespeicher (34), eine Anzeige (44) und eine Steuereinrichtung (38) zur Ansteuerung der Anzeige (44), um mindestens einen Parameter (62) des Elektrogeräts (10, 60) und/oder der Energiespeichervorrichtung darzustellen, umfasst, wobei die Anzeige (44) ausgebildet ist zum Darstellen des mindestens einen Parameters (62) in mindestens zwei verschiedenen Ausrichtungen, **dadurch gekennzeichnet, dass** die Energiespeichervorrichtung (22) eine Dekodiereinrichtung (46) umfasst zum Dekodieren eines am Elektrogerät (10, 60) angeordneten oder in diesem hinterlegten spezifischen Gerätekodes, dass die Dekodiereinrichtung (46) mit der Steuereinrichtung (38) zusammenwirkend ausgebildet ist, dass die Steuereinrichtung (38) ausgebildet ist zum Darstellen des mindestens einen Parameters (62) in einer zum spezifischen Gerätekode korrespondierenden Ausrichtung (72, 74) der mindestens zwei verschiedenen Ausrichtungen (72, 74), dass die elektrische Energiespeichervorrichtung (22) mindestens ein erstes Kopplungselement (26) einer mindestens ein zweites, am Elektrogerät (10, 60) angeordnetes oder ausgebildetes Kopplungselement (28) umfassenden Kopplungseinrichtung (24) zum kraft- und/oder formschlüssigen Koppeln der elektrischen Energiespeichervorrichtung (22) mit einem Elektrogerät (10, 60) in einer Kopplungsstellung umfasst, in welcher die elektrische Energiespeichervorrichtung (22) und das Elektrogerät (10, 60) mechanisch und elektrisch miteinander gekoppelt sind und das mindestens eine erste und das mindestens eine zweite Kopplungselement (26, 28) kraft- und/oder formschlüssig in Eingriff stehen, und dass die Dekodiereinrichtung (46) im Bereich des mindestens einen ersten Kopplungselements (26) derart angeordnet ist, dass der spezifische Gerätekode in der Kopplungsstellung der Kopplungseinrichtung (24) vom Elektrogerät (10, 60) auf die Energiespeichervorrichtung (22) sicher und insbesondere eindeutig übertragbar ist.

2. Elektrische Energiespeichervorrichtung nach Anspruch 1, **dadurch gekennzeichnet, dass** die mindestens zwei Ausrichtungen (72, 74)
a) parallel oder im Wesentlichen parallel zu seitlichen Begrenzungen (68, 70) der Anzeige (44) verlaufen
und/oder
b) um ein ganzzahliges Vielfaches von 90° relativ zueinander im Uhrzeigersinn oder im Gegenuhrzeigersinn verdreht sind.

3. Elektrische Energiespeichervorrichtung nach einem der voranstehenden Ansprüche, **gekennzeichnet durch** eine Empfangseinrichtung (54), welche mit der Dekodiereinrichtung (46) zusammenwirkend und zum Empfangen, insbesondere zum berührungslosen Empfangen, des von einer Sendeeinrichtung (52) des Elektrogeräts (10, 60) gesendeten spezifischen Gerätekodes ausgebildet ist,
wobei insbesondere die Empfangseinrichtung (54) eine RFID-Chip-Ausleseeinrichtung umfasst.

4. Elektrische Energiespeichervorrichtung nach einem der voranstehenden Ansprüche, **dadurch gekennzeichnet, dass** die Dekodiereinrichtung (46) mindestens einen Magnetfeldsensor (58) und/oder eine magnetisch betätigbare Schalteinrichtung umfasst,
wobei insbesondere der Magnetfeldsensor (58) in Form eines Hall-Sensors ausgebildet ist und/oder dass die magnetisch betätigbare Schalteinrichtung einen Reed-Schalter umfasst.

5. Elektrische Energiespeichervorrichtung nach einem der voranstehenden Ansprüche, **dadurch gekennzeichnet, dass** das mindestens eine erste Kopplungselement (26)
a) in Form eines Kopplungsvorsprungs (30) oder in Form einer Kopplungsausnehmung (32) ausgebildet ist
und/oder
b) ausgebildet ist zum wahlweisen Koppeln mit einer Mehrzahl von insbesondere unterschiedlichen Elektrogeräten (10, 60).

6. Elektrische Energiespeichervorrichtung nach einem der voranstehenden Ansprüche, **dadurch gekennzeichnet, dass** die Anzeige (44)
a) in Form einer LED-Segmentanzeige oder in Form eines LCD-Displays oder in Form eines LED-Farbdisplays ausgebildet ist
und/oder
b) ausgebildet ist zum Darstellen des mindestens einen Parameters (62) in zwei, drei oder vier verschiedenen Ausrichtungen (72, 74).

7. Elektrische Energiespeichervorrichtung nach einem der voranstehenden Ansprüche, **dadurch gekennzeichnet, dass**
a) der mindestens eine elektrische Energiespeicher (34) in Form einer wiederaufladbaren Batterie (36) ausgebildet ist
und/oder
b) die elektrische Energiespeichervorrichtung eine Mehrzahl von elektrischen Energiespeichern (34) umfasst.

8. Elektrogerät (10, 60) mit mindestens einem elektrischen Verbraucher (12) und einer elektrischen Energiespeichervorrichtung (22) zum Versorgen des elektrischen Verbrauchers (12) mit elektrischer Energie, **dadurch gekennzeichnet, dass** das Elektrogerät (10, 60) eine Kodiereinrichtung (48) mit einem spezifischen Gerätekode umfasst und dass die elektrische Energiespeichervorrichtung (22) in Form einer elektrischen Energiespeichervorrichtung (22) nach einem der voranstehenden Ansprüche ausgebildet ist.

9. Elektrogerät nach Anspruch 8, **dadurch gekennzeichnet, dass** die Kodiereinrichtung (48; 48') mindestens ein Kodierelement (50; 50') umfasst,
wobei insbesondere das mindestens eine Kodierelement (50) in Form eines magnetischen oder magnetisierbaren Kodierelements (50) ausgebildet ist,
wobei weiter insbesondere das magnetische Kodierelement (50) in Form eines Dauermagneten oder in Form eines Elektromagneten ausgebildet ist.

10. Elektrogerät nach Anspruch 8 oder 9, **dadurch gekennzeichnet, dass**
a) die Kodiereinrichtung (48; 48') mindestens ein Speicherelement umfasst und dass der spezifische Gerätekode auf dem Speicherelement gespeichert ist
und/oder
b) das Elektrogerät (10, 60) eine Sendeeinrichtung (52) umfasst, dass die Kodiereinrichtung (48; 48') mit der Sendeeinrichtung (52) zusammenwirkend ausgebildet ist, dass die Dekodiereinrichtung (46) mit einer Empfangseinrichtung (54) zusammenwirkend ausgebildet ist und dass die Sendeeinrichtung (52) ausgebildet ist zum Senden, insbesondere zum berührungslosen Senden, des spezifischen Gerätekodes an die Empfangseinrichtung (54)
und/oder
c) die Kodiereinrichtung (48; 48') einen RFID-Chip umfasst.

11. Elektrogerät nach einem der Ansprüche 8 bis 10, **gekennzeichnet durch** eine Kopplungseinrichtung (24) zum kraft- und/oder formschlüssigen Koppeln des Elektrogeräts (10, 60) und der elektrischen Energiespeichervorrichtung (22) in einer Kopplungsstellung, in welcher das Elektrogerät (10, 60) und die elektrische Energiespeichervorrichtung (22) mechanisch und elektrisch miteinander gekoppelt sind.

12. Elektrogerät nach Anspruch 11, **dadurch gekennzeichnet, dass**
a) die Kopplungseinrichtung (24) mindestens ein erstes Kopplungselement (26) und mindestens ein zweites Kopplungselement (28) umfasst, dass das mindestens eine erste Kopplungselement (26) an der elektrischen Energiespeichervorrichtung (22) angeordnet oder ausgebildet ist, dass das mindestens eine zweite Kopplungselement (28) am Elektrogerät (10, 60) angeordnet oder ausgebildet und dass das mindestens eine erste und das mindestens eine zweite Kopplungselement (26, 28) in der Kopplungsstellung kraft- und/oder formschlüssig in Eingriff stehen,
wobei insbesondere das mindestens eine erste und das mindestens eine zweite Kopplungselement (26, 28) in einer Trennstellung, in welcher das Elektrogerät und die elektrische Energiespeichervorrichtung (22) vollständig voneinander getrennt sind, außer Eingriff stehen,
und/oder
b) die Kodiereinrichtung (48; 48') und die Dekodiereinrichtung (46) in der Kopplungsstellung derart angeordnet sind, dass der spezifische Gerätekode mit der Dekodiereinrichtung (46) dekodierbar ist.

13. Elektrogerät nach Anspruch 12, **dadurch gekennzeichnet, dass** die Kodiereinrichtung (48) im Bereich des mindestens einen zweiten Kopplungselements (28) derart angeordnet ist, dass der spezifische Gerätekode in der Kopplungsstellung der Kopplungseinrichtung (24) vom Elektrogerät (10) auf die Energiespeichervorrichtung (22) sicher und insbesondere eindeutig übertragbar ist.

14. Elektrogerät nach einem der Ansprüche 8 bis 13, **dadurch gekennzeichnet, dass**
a) das Elektrogerät (10, 60) ausgebildet ist zum wahlweisen Koppeln mit einer Mehrzahl von insbesondere unterschiedlichen elektrischen Energiespeichervorrichtungen (22)
und/oder
b) der elektrische Verbraucher (12) in Form eines Elektromotors (14) ausgebildet ist.

15. Verfahren zum Darstellen mindestens eines Parameter (62) eines Elektrogeräts (10, 60) und/oder einer elektrischen Energiespeichervorrichtung (22) auf einer Anzeige (44) der elektrischen Energiespeichervorrichtung (22), welche Anzeige (44) ausgebildet ist zum Darstellen des mindestens einen Parameters in mindestens zwei verschiedenen Ausrichtungen (72, 74), **dadurch gekennzeichnet, dass** die elektrische Energiespeichervorrichtung (22) mindestens ein erstes Kopplungselement (26) einer mindestens ein zweites, am Elektrogerät (10, 60) angeordnetes oder ausgebildetes Kopplungselement (28) umfassenden Kopplungseinrichtung (24) zum kraft- und/oder formschlüssigen Koppeln der elektrischen Energiespeichervorrichtung (22) mit einem Elektrogerät (10, 60) in einer Kopplungsstellung umfasst, in welcher die elektrische Energiespeichervorrichtung (22) und das Elektrogerät (10, 60) mechanisch und elektrisch miteinander gekoppelt sind und das mindestens eine erste und das mindestens eine zweite Kopplungselement (26, 28) kraft- und/oder formschlüssig in Eingriff stehen, dass die elektrische Energiespeichervorrichtung (22) und das Elektrogerät (10, 60) mechanisch und elektrisch miteinander gekoppelt werden, so dass sie die Kopplungsstellung einnehmen, und dass ein am Elektrogerät (10, 60) angeordneter oder in diesem hinterlegter spezifischer Gerätekode ausgelesen und der mindestens eine Parameter (62) in einer zum spezifischen Gerätekode korrespondierenden Ausrichtung (72, 74) der mindestens zwei verschiedenen Ausrichtungen (72, 74) auf der Anzeige (44) dargestellt wird.

## Claims

1. Electrical energy storage device (22) for an electrical appliance (10, 60) having at least one electrical consuming device (12), which electrical energy storage device (22) comprises at least one electrical energy store (34), a display (44) and a control device (38) for controlling the display (44) in order to show at least one parameter (62) of the electrical appliance (10, 60) and/or the energy storage device, wherein the display (44) is designed to show the at least one parameter (62) in at least two different orientations, **characterised in that** the energy storage device (22) comprises a decoding device (46) for decoding a specific appliance code arranged at the electrical appliance (10, 60) or saved therein, **in that** the decoding device (46) is designed to cooperate with the control device (38), **in that** the control device (38) is designed to show the at least one parameter (62) in one orientation (72, 74), corresponding to the specific appliance code, of the at least two different orientations (72, 74), **in that** the electrical energy storage device (22) comprises at least one first coupling element (26) of a coupling device (24), comprising at least one second coupling element (28) arranged or formed on the electrical appliance (10, 60), for the force-locked and/or form-locked coupling of the electrical energy storage device (22) with an electrical appliance (10, 60) in a coupling position in which the electrical energy storage device (22) and the electrical appliance (10, 60) are mechanically and electrically coupled with one another and the at least one first and the at least one second coupling element (26, 28) are engaged in a force-locked and/or form-locked manner, and **in that** the decoding device (46) is arranged in the region of the at least one first coupling element (26) in such a manner that the specific appliance code can be transmitted in a reliable and in particular clear manner from the electrical appliance (10, 60) to the energy storage device (22) in the coupling position of the coupling device (24).

2. Electrical energy storage device according to claim 1, **characterised in that** the at least two orientations (72, 74)
a) run parallel or substantially parallel to lateral boundaries (68, 70) of the display (44)
and/or
b) are rotated by an integral multiple of 90° relative to one another in the clockwise or counter-clockwise direction.

3. Electrical energy storage device according to any one of the preceding claims, **characterised by** a receiving device (54) which is designed to cooperate with the decoding device (46) and which is designed to receive, in particular to receive in a contactless manner, the specific appliance code sent by a sending device (52) of the electrical appliance (10, 60),
wherein in particular the receiving device (54) comprises a RFID chip read-out device.

4. Electrical energy storage device according to any one of the preceding claims, **characterised in that** the decoding device (46) comprises at least one magnetic-field sensor (58) and/or a magnetically actuatable switching device,
wherein in particular the magnetic-field sensor (58) is in the form of a Hall-effect sensor and/or **in that** the magnetically actuatable switching device comprises a reed switch.

5. Electrical energy storage device according to any one of the preceding claims, **characterised in that** the at least one first coupling element (26)
a) is in the form of a coupling projection (30) or in the form of a coupling cutout (32)
and/or
b) is designed for selective coupling with a plurality of in particular different electrical appliances (10, 60).

6. Electrical energy storage device according to any one of the preceding claims, **characterised in that** the display (44)
a) is in the form of an LED segment display or in the form of an LCD display or in the form of an LED colour display
and/or
b) is designed to show the at least one parameter (62) in two, three or four different orientations (72, 74).

7. Electrical energy storage device according to any one of the preceding claims, **characterised in that**
a) the at least one electrical energy store (34) is in the form of a rechargeable battery (36)
and/or
b) the electrical energy storage device comprises a plurality of electrical energy stores (34).

8. Electrical appliance (10, 60) having at least one electrical consuming device (12) and an electrical energy storage device (22) for supplying the electrical consuming device (12) with electrical energy, **characterized in that** the electrical appliance (10, 60) comprises a coding device (48) with a specific appliance code and **in that** the electrical energy storage device (22) is in the form of an electrical energy storage device (22) according to any one of the preceding claims.

9. Electrical appliance according to claim 8, **characterised in that** the coding device (48; 48') comprises at least one coding element (50; 50'), wherein in particular the at least one coding element (50) is in the form of a magnetic or magnetisable coding element (50)
wherein furthermore in particular the magnetic coding element (50) is in the form of a permanent magnet or in the form of an electromagnet.

10. Electrical appliance according to claim 8 or 9, **characterised in that**
a) the coding device (48; 48') comprises at least one storage element and **in that** the specific appliance code is stored on the storage element
and/or
b) the electrical appliance (10, 60) comprises a sending device (52), **in that** the coding device (48; 48') is designed to cooperate with the sending device (52), **in that** the decoding device (46) is designed to cooperate with a receiving device (54), and **in that** the sending device (52) is designed for sending, in particular contactless sending, of the specific appliance code to the receiving device (54)
and/or
c) the coding device (48; 48') comprises an RFID chip.

11. Electrical appliance according to any one of claims 8 to 10, **characterised by** a coupling device (24) for the force-locked and/or form-locked coupling of the electrical appliance (10, 60) and the electrical energy storage device (22) in a coupling position in which the electrical appliance (10, 60) and the electrical energy storage device (22) are mechanically and electrically coupled to one another.

12. Electrical appliance according to claim 11, **characterised in that**
a) the coupling device (24) comprises at least one first coupling element (26) and at least one second coupling element (28), **in that** the at least one first coupling element (26) is arranged or formed at the electrical energy storage device (22), **in that** the at least one second coupling element (28) is arranged or formed at the electrical appliance (10, 60) and **in that** the at least one first and the at least one second coupling element (26, 28) engage in a force-locked and/or form-locked manner in the coupling position, wherein in particular the at least one first and the at least one second coupling element (26, 28) are disengaged in a separating position in which the electrical appliance and the electrical energy storage device (22) are completely separated from one another,
and/or
b) the coding device (48; 48') and the decoding device (46) are in the coupling position arranged in such a manner that the specific appliance code can be decoded with the decoding device (46).

13. Electrical appliance according to claim 12, **characterised in that** the coding device (48) is arranged in the region of the at least one second coupling element (28) in such a manner that the specific appliance code can be transmitted in a reliable and in particular clear manner from the electrical appliance (10) to the energy storage device (22) in the coupling position of the coupling device (24).

14. Electrical appliance according to any one of claims 8 to 13, **characterised in that**
a) the electrical appliance (10, 60) is designed for selective coupling with a plurality of in particular different electrical energy storage devices (22)
and/or
b) the electrical consuming device (12) is in the form of an electric motor (14).

15. Method of showing at least one parameter (62) of an electrical appliance (10, 60) and/or of an electrical energy storage device (22) on a display (44) of the electrical energy storage device (22), which display (44) is designed to show the at least one parameter in at least two different orientations (72, 74), **characterised in that** the electrical energy storage device (22) comprises at least one first coupling element (26) of a coupling device (24), comprising at least one second coupling element (28) arranged or formed on the electrical appliance (10, 60), for the force-locked and/or form-locked coupling of the electrical energy storage device (22) with an electrical appliance (10, 60) in a coupling position in which the electrical energy storage device (22) and the electrical appliance (10, 60) are mechanically and electrically coupled with one another and the at least one first and the at least one second coupling element (26, 28) are engaged in a force-locked and/or form-locked manner, **in that** the electrical energy storage device (22) and the electrical appliance (10, 60) are mechanically and electrically coupled to one another, so that they occupy the coupling position, and **in that** a specific appliance code arranged at the electrical appliance (10, 60) or saved therein is read out and the at least one parameter (62) is shown on the display (44) in one orientation (72, 74), corresponding to the specific appliance code, of the at least two different orientations (72, 74).

## Revendications

1. Dispositif d'accumulation d'énergie électrique (22) pour un appareil électrique (10, 60), comprenant au moins un consommateur électrique (12), lequel dispositif d'accumulation d'énergie électrique (22) comporte au moins un accumulateur d'énergie électrique (34), un écran (44) et un dispositif de commande (38) destiné à commander l'écran (44), afin de représenter au moins un paramètre (62) de l'appareil électrique (10, 60) et/ou du dispositif d'accumulation d'énergie, dans lequel l'écran (44) est conçu pour représenter le au moins un paramètre (62) dans au moins deux orientations différentes, **caractérisé en ce que** le dispositif d'accumulation d'énergie (22) comporte un dispositif de décodage (46) destiné à décoder un code d'appareil spécifique situé sur l'appareil électrique (10, 60) ou mis en mémoire dans celui-ci, **en ce que** le dispositif de décodage (46) est conçu pour coopérer avec le dispositif de commande (38), **en ce que** le dispositif de commande (38) est conçu pour représenter le au moins un paramètre (62) dans une orientation (72, 74) correspondant au code d'appareil spécifique parmi les au moins deux orientations (72, 74) différentes, **en ce que** le dispositif d'accumulation d'énergie électrique (22) comporte au moins un premier élément d'accouplement (26) d'un dispositif d'accouplement (24) comportant au moins un deuxième élément d'accouplement (28) agencé ou formé sur l'appareil électrique (10, 60), pour l'accouplement à force et/ou par complémentarité de formes du dispositif d'accumulation d'énergie électrique (22) à un appareil électrique (10, 60) dans une position d'accouplement, dans laquelle le dispositif d'accumulation d'énergie électrique (22) et l'appareil électrique (10, 60) sont accouplés mécaniquement et électriquement l'un à l'autre et le au moins un premier et le au moins un deuxième élément d'accouplement (26, 28) sont en prise à force et/ou par complémentarité de formes, et **en ce que** le dispositif de décodage (46) est agencé dans la zone du au moins un premier élément d'accouplement (26) de telle sorte que le code d'appareil spécifique, dans la position d'accouplement du dispositif d'accouplement (24), peut être transmis de l'appareil électrique (10, 60) au dispositif d'accumulation d'énergie (22) de façon sûre et en particulier univoque.

2. Dispositif d'accumulation d'énergie électrique selon la revendication 1, **caractérisé en ce que** les au moins deux orientations (72, 74)
a) s'étendent parallèlement ou sensiblement parallèlement aux délimitations latérales (68, 70) de l'écran (44)
et/ou
b) sont amenées en rotation d'un multiple entier de 90° l'une par rapport à l'autre dans le sens horaire ou dans le sens antihoraire.

3. Dispositif d'accumulation d'énergie électrique selon l'une quelconque des revendications précédentes, **caractérisé par** un dispositif de réception (54), lequel est conçu pour coopérer avec le dispositif de décodage (46) et pour recevoir, en particulier pour recevoir sans contact, le code d'appareil spécifique envoyé par un dispositif d'émission (52) de l'appareil électrique (10, 60),
dans lequel en particulier le dispositif de réception (54) comporte un dispositif de lecture à puce RFID.

4. Dispositif d'accumulation d'énergie électrique selon l'une quelconque des revendications précédentes, **caractérisé en ce que** le dispositif de décodage (46) comporte au moins un capteur de champ magnétique (58) et/ou un dispositif de commutation à actionnement magnétique,
dans lequel en particulier le capteur de champ magnétique (58) est réalisé sous la forme d'un capteur à effet Hall et/ou **en ce que** le dispositif de commutation à actionnement magnétique comporte un commutateur Reed.

5. Dispositif d'accumulation d'énergie électrique selon l'une quelconque des revendications précédentes, **caractérisé en ce que** le au moins un premier élément d'accouplement (26)
a) est réalisé sous la forme d'une partie saillante d'accouplement (30) ou sous la forme d'un évidement d'accouplement (32)
et/ou
b) est conçu pour être accouplé sélectivement à une pluralité d'appareils électriques (10, 60) en particulier différents.

6. Dispositif d'accumulation d'énergie électrique selon l'une quelconque des revendications précédentes, **caractérisé en ce que** l'écran (44)
a) est réalisé sous la forme d'un écran à segments à DEL ou sous la forme d'un écran LCD ou sous la forme d'un écran couleur à DEL
et/ou
b) est conçu pour représenter le au moins un paramètre (62) dans deux, trois ou quatre orientations (72, 74) différentes.

7. Dispositif d'accumulation d'énergie électrique selon l'une quelconque des revendications précédentes, **caractérisé en ce que**
a) le au moins un accumulateur d'énergie électrique (34) est réalisé sous la forme d'une batterie rechargeable (36)
et/ou
b) le dispositif d'accumulation d'énergie électrique comporte une pluralité d'accumulateurs d'énergie électrique (34).

8. Appareil électrique (10, 60) comprenant au moins un consommateur électrique (12) et un dispositif d'accumulation d'énergie électrique (22) destiné à alimenter le consommateur électrique (12) en énergie électrique, **caractérisé en ce que** l'appareil électrique (10, 60) comporte un dispositif de codage (48) pourvu d'un code d'appareil spécifique et **en ce que** le dispositif d'accumulation d'énergie électrique (22) est réalisé sous la forme d'un dispositif d'accumulation d'énergie électrique (22) selon l'une quelconque des revendications précédentes.

9. Appareil électrique selon la revendication 8, **caractérisé en ce que** le dispositif de codage (48 ; 48') comporte au moins un élément de codage (50 ; 50'),
dans lequel en particulier le au moins un élément de codage (50) est réalisé sous la forme d'un élément de codage (50) magnétique ou magnétisable,
dans lequel, en outre, en particulier l'élément de codage (50) magnétique est réalisé sous la forme d'un aimant permanent ou sous la forme d'un électro-aimant.

10. Appareil électrique selon la revendication 8 ou 9, **caractérisé en ce que**
a) le dispositif de codage (48 ; 48') comporte au moins un élément mémoire et **en ce que** le code d'appareil spécifique est mis en mémoire sur l'élément de mémoire,
et/ou
b) l'appareil électrique (10, 60) comporte un dispositif d'émission (52), **en ce que** le dispositif de codage (48 ; 48') est conçu pour coopérer avec le dispositif d'émission (52), **en ce que** le dispositif de décodage (46) est conçu pour coopérer avec un dispositif de réception (54) et **en ce que** le dispositif d'émission (52) est conçu pour envoyer, en particulier pour envoyer sans contact, le code d'appareil spécifique au dispositif de réception (54)
et/ou
c) le dispositif de codage (48 ; 48') comporte une puce RFID.

11. Appareil électrique selon l'une quelconque des revendications 8 à 10, **caractérisé par** un dispositif d'accouplement (24) pour l'accouplement à force et/ou par complémentarité de formes de l'appareil électrique (10, 60) et du dispositif d'accumulation d'énergie électrique (22) dans une position d'accouplement, dans laquelle l'appareil électrique (10, 60) et le dispositif d'accumulation d'énergie électrique (22) sont accouplés l'un à l'autre mécaniquement et électriquement.

12. Appareil électrique selon la revendication 11, **caractérisé en ce que**
a) le dispositif d'accouplement (24) comporte au moins un premier élément d'accouplement (26) et au moins un deuxième élément d'accouplement (28), **en ce que** le au moins un premier élément d'accouplement (26) est agencé ou formé sur le dispositif d'accumulation d'énergie électrique (22), **en ce que** le au moins un deuxième élément d'accouplement (28) est agencé ou formé sur l'appareil électrique (10, 60) et **en ce que** le au moins un premier et le au moins un deuxième élément d'accouplement (26, 28) sont en prise à force et/ou par complémentarité de formes dans la position d'accouplement,
dans lequel, en particulier, le au moins un premier et le au moins un deuxième élément d'accouplement (26, 28) ne sont pas en prise dans une position de séparation, dans laquelle l'appareil électrique et le dispositif d'accumulation d'énergie électrique (22) sont complètement séparés l'un de l'autre,
et/ou
b) le dispositif de codage (48 ; 48') et le dispositif de décodage (46), dans la position d'accouplement, sont agencés de telle sorte que le code d'appareil spécifique peut être décodé au moyen du dispositif de décodage (46).

13. Appareil électrique selon la revendication 12, **caractérisé en ce que** le dispositif de codage (48) est agencé dans la zone du au moins un deuxième élément d'accouplement (28), de telle manière que le code d'appareil spécifique, dans la position d'accouplement du dispositif d'accouplement (24), peut être transmis de l'appareil électrique (10) au dispositif d'accumulation d'énergie électrique (22) de façon sûre et en particulier univoque.

14. Appareil électrique selon l'une quelconque des revendications 8 à 13, **caractérisé en ce que**
a) l'appareil électrique (10, 60) est conçu pour être accouplé sélectivement à une pluralité de dispositifs d'accumulation d'énergie électrique (22) en particulier différents,
et/ou
b) le consommateur électrique (12) est réalisé sous la forme d'un moteur électrique (14).

15. Procédé pour représenter au moins un paramètre (62) d'un appareil électrique (10, 60) et/ou d'un dispositif d'accumulation d'énergie électrique (22) sur un écran (44) du dispositif d'accumulation d'énergie électrique (22), lequel écran (44) est conçu pour représenter le au moins un paramètre dans au moins deux orientations (72, 74) différentes, **caractérisé en ce que** le dispositif d'accumulation d'énergie électrique (22) comporte au moins un premier élément d'accouplement (26) d'un dispositif d'accouplement (24) comportant au moins un deuxième élément d'accouplement (28) agencé ou formé sur l'appareil électrique (10, 60), pour l'accouplement à force et/ou par complémentarité de formes du dispositif d'accumulation d'énergie électrique (22) à un appareil électrique (10, 60) dans une position d'accouplement, dans laquelle le dispositif d'accumulation d'énergie électrique (22) et l'appareil électrique (10, 60) sont accouplés l'un à l'autre mécaniquement et électriquement et le au moins un premier et le au moins un deuxième élément d'accouplement (26, 28) sont en prise à force et/ou par complémentarité de formes, **en ce que** le dispositif d'accumulation d'énergie électrique (22) et l'appareil électrique (10, 60) sont accouplés mécaniquement et électriquement l'un à l'autre, de sorte qu'ils occupent la position d'accouplement, et **en ce qu'**un code d'appareil spécifique situé sur l'appareil électrique (10, 60) ou mis en mémoire dans celui-ci est lu et le au moins un paramètre (62) est représenté sur l'écran (44) dans une orientation (72, 74), correspondant au code d'appareil spécifique, parmi les au moins deux orientations (72, 74) différentes.
